Europäisches Patentamt

European Patent Office

Office européen des brevets

(19)

(11) Numéro de publication: **0 088 669**
**B1**

(12)

# FASCICULE DE BREVET EUROPEEN

(45) Date de publication du fascicule du brevet:
06.08.86

(21) Numéro de dépôt: 83400388.1

(22) Date de dépôt: 25.02.83

(51) Int. Cl.⁴: **H 03 B 23/00**

(54) Dispositif de génération numérique d'un signal modulé en fréquence, et dispositif radiofréquence comprenant un tel dispositif numérique.

(30) Priorité: 05.03.82 FR 8203733

(43) Date de publication de la demande:
14.09.83 Bulletin 83/37

(45) Mention de la délivrance du brevet:
06.08.86 Bulletin 86/32

(84) Etats contractants désignés:
DE GB IT NL SE

(56) Documents cités:
US - A - 3 364 437
US - A - 3 548 320
US - A - 3 551 826
US - A - 3 621 403
US - A - 3 792 378
US - A - 4 160 958
US - A - 4 249 138

(73) Titulaire: THOMSON-CSF, 173, Boulevard Haussmann,
F-75379 Paris Cedex 08 (FR)

(72) Inventeur: Chanrion, Jean-Claude, THOMSON-CSF
SCPI 173, bld Haussmann, F-75379 Paris Cedex 08 (FR)

ACTORUM AG

# Description

La présente invention concerne un dispositif numérique de génération d'un signal modulé en fréquence et un dispositif radiofréquence comprenant un tel dispositif numérique.

Il est parfois nécessaire de générer un signal portant une modulation de fréquence ou de phase très précise. C'est par exemple le cas des altimètres ou des télémètres qui utilisent un signal modulé linéairement en fréquence.

Les circuits générant un tel signal peuvent être réalisés en technique purement analogique qui nécessite des composants de très haute qualité ou en technique numérique utilisant des déphaseurs programmables, comme dans le brevet américain US-A-4 160 958. Outre sa complexité de réalisation, cette dernière technique a pour principal inconvénient d'utiliser un déphaseur programmable qui reste un élément analogique de précision et dont la réalisation est particulièrement délicate si l'on désire une bonne stabilité en température et dans le temps.

Un dispositif de génération numérique d'un signal modulé en fréquence selon une loi déterminée est également connu du document US-A-3 621 403.

Ce dispositif comporte une horloge de période $T = 1/f_H$, un moyen diviseur programmable générant un signal impulsionnel R dont chaque période d'ordre i est un multiple entier $N_i$ supérieur à 1, i variant de 0 à n, de la période T de l'horloge, et dont la largeur d'impulsion est égale à une période T d'horloge, un moyen de mise en forme du signal impulsionnel R en un signal S dont les (n+1) alternances correspondent respectivement aux (n+1) périodes du signal impulsionnel R, et un moyen de commande du moyen diviseur programmable, auquel il fournit successivement chacun des nombres naturels $N_0,...N_n$, comme le dispositif de l'invention.

Ce dispositif ne permet cependant pas d'obtenir une grand précision de la modulation de fréquence du signal S par rapport à la loi de modulation désirée, par le fait que les fronts du signal S modulé en fréquence sont nécessairement attachés à ceux de l'horloge de référence.

Le dispositif numérique selon l'invention permet d'éviter cet inconvénient.

Le dispositif selon l'invention est caractérisé en ce que ledit moyen de commande assure la réinitialisation dudit moyen de mise en forme et en ce que le dispositif comprend en outre un moyen de retard pour délivrer sur (M+1) sorties le signal fourni par le moyen programmable (1) et retardé respectivement de $\frac{jT}{M+1}$, j variant de 0 à M, T étant la période d'horloge et M étant un nombre naturel supérieur ou égal à 1, et un moyen permettant de sélectionner, pour chaque cycle de comptage d'ordre i, un des (M+1) signaux de sortie du moyen de retard.

Le dispositif numérique selon l'invention ne nécessite aucun réglage et permet de générer avec une grande précision toute forme de modulation de fréquence quelle que soit la fréquence porteuse.

Le dispositif numérique objet de la présente invention présente également l'avantage d'être simple, peu coûteux, fiable et insensible à la température et au vieillissement.

La présente invention a pour objet un dispositif de génération numérique d'un signal modulé en fréquence, selon une loi déterminée, tel que défini dans les revendications.

La présente invention sera mieux comprise à la lecture de la description détaillée faite ci-après avec référence aux figures ci-annexées qui représentent:

Fig. 1, le schéma synoptique du dispositif numérique selon l'invention;

Fig. 3 et 4, deux modes de réalisation d'une partie du dispositif numérique, objet de la présente invention;

Fig. 5, la représentation de l'erreur de phase entre le signal réel et le signal théorique;

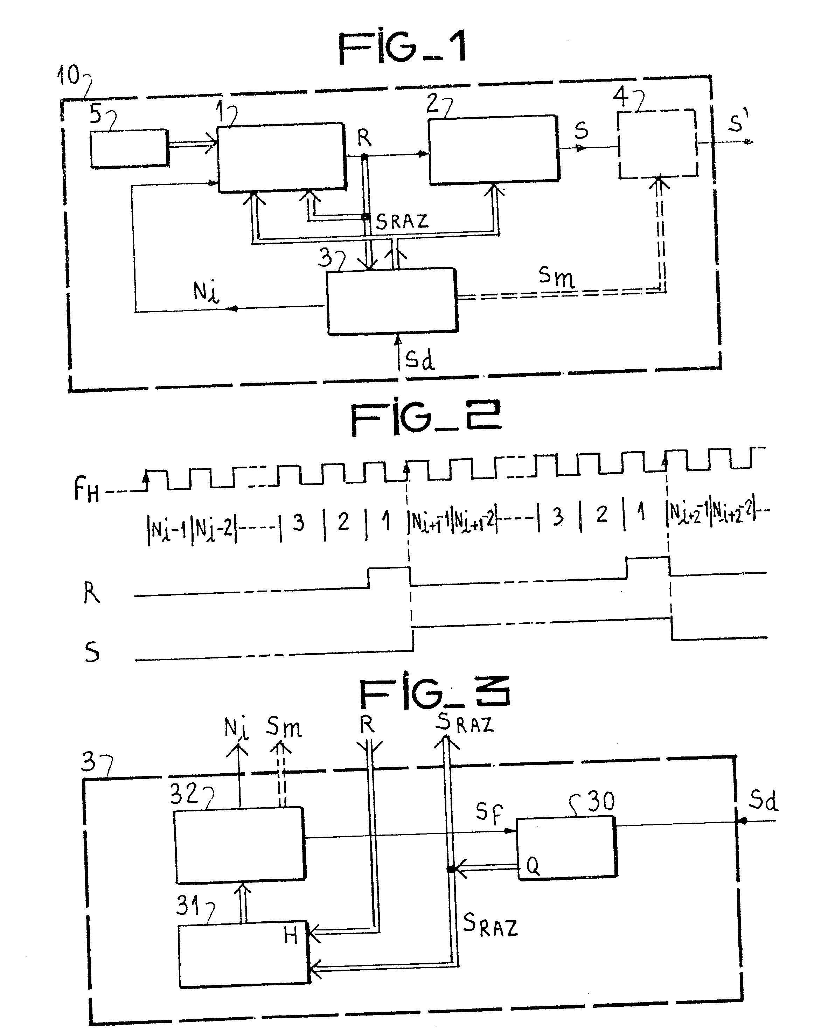

Fig. 2, les signaux en différents points du dispositif de la fig. 1,

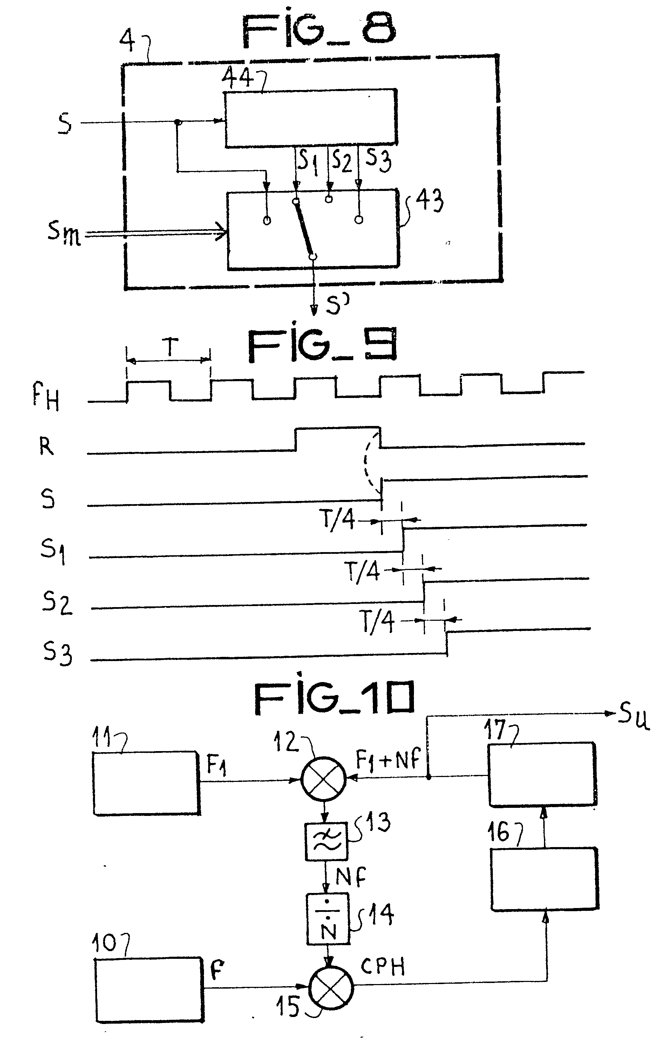

Fig. 6 et 8, deux modes de réalisation d'une partie du dispositif selon l'invention.

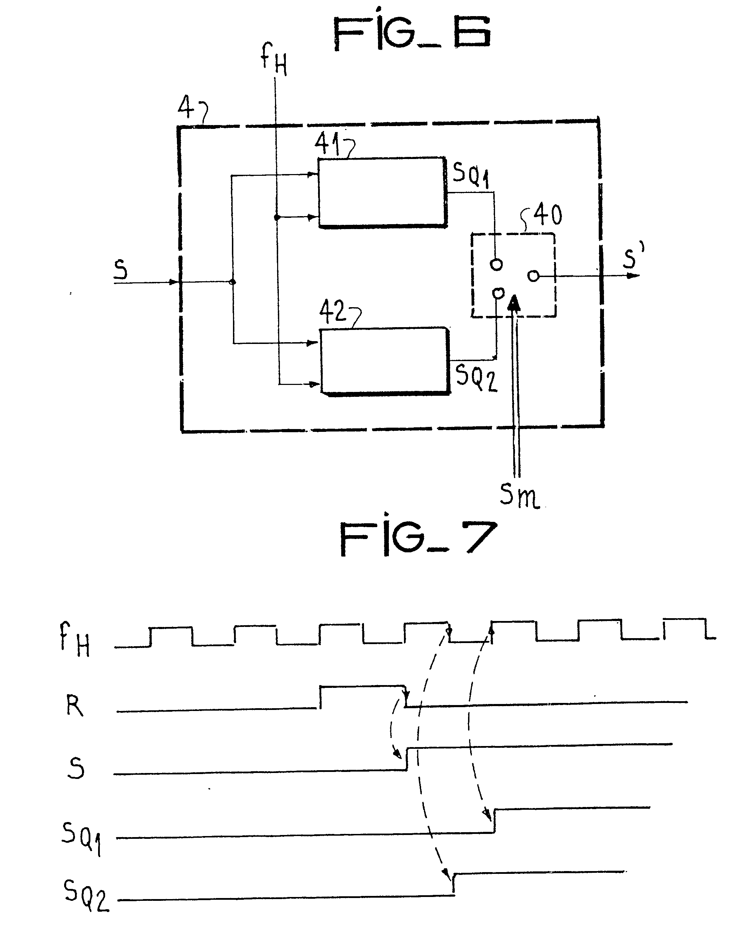

Fig. 7 et 9, les signaux en différents points du circuit des fig. 6 et 8 respectivement; et

Fig. 10, l'utilisation dans un boucle de phase du circuit selon l'invention.

La fig. 1 représente le schéma synoptique du dispositif numérique 10 selon l'invention, permettant de générer un signal modulé en fréquence.

Le signal désiré S est obtenu par une division, dans un circuit 1 programmable, de la fréquence $f_H$ d'une horloge de référence 5. Le rang de la division peut être modifié d'un cycle de comptage au suivant. Ceci permet de générer un signal impulsionnel R dont chaque cycle présente une durée variable $N_0T, N_1T,...,N_iT,...,N_nT$, avec $N_i$ (i = 0,...,n) un nombre entier naturel quelconque fourni par un circuit 3 et $T = \dfrac{1}{f_H}$

la période du signal horloge. Selon un mode de réalisation préférentiel le circuit 1 est un décompteur programmable dont le fonctionnement est décrit ultérieurement dans la description.

Le signal R à impulsions fines alimente un circuit 2, que l'on appellera diviseur par deux, qui lui donne un facteur de forme proche de ½ et le circuit de commande 3. Chaque alternance du signal carré S ainsi obtenu présente une durée variable $N_0T,...,N_iT,...,N_nT$.

C'est un signal modulé en fréquence.

Un circuit supplémentaire 4 permet d'améliorer la précision de la modulation de fréquence du signal S par rapport à la loi de modulation désirée. Le signal délivré par ce circuit 4 est désigné par S'. Ce circuit 4 peut dans certains modes de réalisation être inséré entre le circuit diviseur 1 et le circuit 2 diviseur par deux.

Ce point sera précisé par la suite dans la description des figures 6 et 8 donnant deux exemples de mode de réalisation non limitatifs de ce circuit 4.

Le circuit 3 fournissant les rangs de division successifs No,...,Ni,...,Nn commande également la mise en route du dispositif 10 sur ordre extérieur Sd, l'arrêt et la réinitialisation des circuits 1 et 2 par le signal $S_{RAZ}$ et du circuit 4 éventuellement par le signal Sm.

Le principe de fonctionnement du dispositif de génération numérique est décrit ci-après en se référant aux fig. 1 et 2.

La fig. 2 représente les signaux en différents points du dispositif dans lequel, selon un mode de réalisation non limitatif, le circuit diviseur programmable 1 est un décompteur qui après avoir été chargé par une valeur $N_i-1$ à partir du rang Ni (par l'intermédiaire d'un circuit soustracteur non représenté) fourni par le circuit 3 effectue à partir de cette valeur une décrémentation d'une unité à chaque cycle d'horloge jusqu'à atteindre la valeur 0. En même temps que le décompteur programmable 1 affiche la valeur 0 il délivre une impulsion R dite de retenue qui commande également l'émission par le circuit 3 de la valeur $N_{i+1}$ suivante du rang de la division et le chargement de la valeur $N_{i+1}-1$ dans le décompteur 1. Le décompteur 1 est comme précédemment décrémenté d'une unité à chaque pas d'horloge et délivre une impulsion de retenue lorsqu'il atteint 0. Il est alors chargé par la valeur $N_{i+2}-1$ et ainsi de suite jusqu'à ce que la série des rangs Ni soit épuisée et la séquence désirée terminée.

Selon un autre mode de réalisation (non représenté), le circuit diviseur programmable 1 peut être un compteur qui après avoir été chargé par une valeur $N_M+1-N_i$, $N_M$ étant la valeur maximum que peut afficher le compteur et Ni étant le rang de la division fourni par le circuit 3, effectue à partir de cette valeur une incrémentation d'une unité à chaque cycle d'horloge jusqu'à atteindre la valeur $N_M$. En même temps que le compteur programmable affiche la valeur $N_M$ il délivre une impulsion R de retenue qui commande également l'émission par le circuit 3 du rang de division $N_{i+1}$ suivant et le chargement de la valeur $N_M+1-N_{i+1}$ dans le compteur et ainsi de suite.

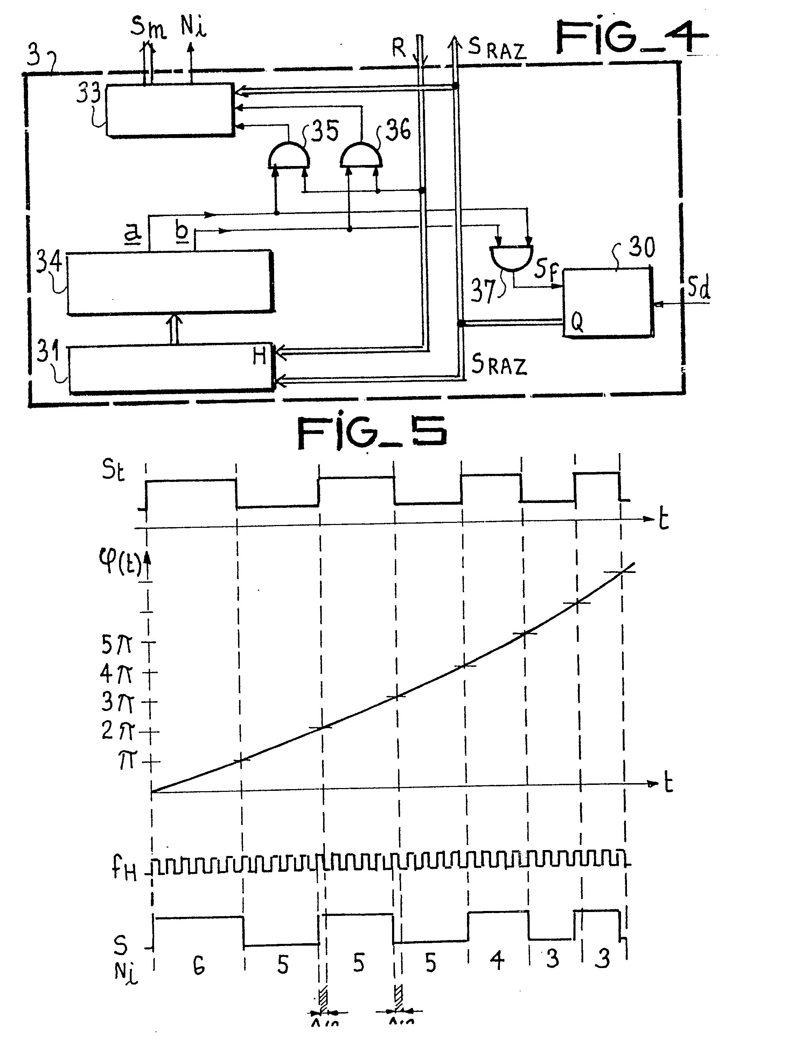

Comme on l'a déjà mentionné la mise en route, l'arrêt et la réinitialisation des circuits du dispositif 10 lorsque la séquence désirée a été obtenue sont assurés par le circuit de commande 3 dont plusieurs modes de réalisation non limitatifs sont donnés dans les fig. 3 et 4.

Le circuit 2 diviseur par deux alimenté par le signal R formé d'impulsions fines, chaque période ayant une durée variable $N_i T$, délivre un signal dont chacune des alternances a une durée variable $N_0 T$, $N_1 T$,..., $N_i T$,..., $N_n T$ et recouvre une période du signal de retenue R.

Ce signal présente une modulation de fréquence et sa loi de phase définie par la suite $N_1$...,$N_i$,..., $N_n$ est très proche de celle du signal désiré.

Le dispositif 10 peut par conséquent, par un choix approprié des rangs Ni de division, générer toute forme de modulation de fréquence, la plus simple étant une modulation linéaire.

Un tel dispositif numérique travaille dans une gamme de fréquence allant du continu à quelques dizaines de Megahertz. Mais en l'insérant dans une boucle de phase selon une technique bien connue, on peut obtenir la modulation désirée sur n'importe quelle fréquence porteuse. Une telle boucle de phase est représentée sur la fig. 10 qui sera décrite en détail plus loin. Le dispositif 10 objet de la présente invention y alimente un comparateur de phase. Il est à souligner que seule la phase est exploitée et que la forme du signal est une caractéristique secondaire et sera traitée comme telle dans la suite de la description. Le but de l'invention est donc de générer un signal carré modulé en fréquence.

La fig. 3 représente un mode de réalisation détaillé du circuit de commande 3. Il comprend une mémoire 32 contenant les (n+1) rangs de division No,..., Ni,..., Nn qui décrémentés de 1 doivent être successivement chargés dans le décompteur programmable 1 de la fig. 1. Cette mémoire 32 contient également un élément binaire qu'elle émet sous la forme d'un signal Sf de fin de séquence en direction d'une bascule R/S 30 lorsque son contenu a été entièrement exploré. Cette bascule 30 reçoit sur sa deuxième entrée un signal extérieur Sd destiné à déclencher l'exploration du contenu mémoire et le fonctionnement du dispositif 10. La sortie de la bascule R/S 30 est un signal $S_{RAZ}$ de remise à zéro ou réinitialisation des circuits décompteur programmable 1 et diviseur par deux 2 de la fig. 1 et d'un compteur d'adresses 31 qui commande l'exploration du contenu de la mémoire 32. L'incrémentation du compteur d'adresses 31 d'une unité est déclenchée par l'arrivée d'une impulsion R de retenue émise par le décompteur programmable 1 lorsqu'il affiche la valeur 0.

Si le dispositif de génération numérique 10 comprend également un circuit 4 permettant d'améliorer la précision de la loi de phase du signal S obtenu en sortie du circuit 2 diviseur par deux, la mémoire 32 contient un élément binaire supplémentaire destiné à commander ce circuit 4 et émis sous la forme d'un signal de commande Sm.

La fig. 4 représente un autre mode de réalisation du circuit 3 de la fig. 1.

La variation de la fréquence du signal désiré est très souvent faible d'une alternance à la suivante. L'écart entre deux rangs de division successifs $N_{i+1}-N_i$ est, alors, très faible c'est-à-dire au plus égal à un. Ce cas est étudié ci-après en se référant également à la fig. 5 qui représente l'approche d'un signal théorique $S_t$ de loi de phase $\varphi(t)$ par un signal S généré par le dispositif de génération 10 à partir du signal horloge $f_H$ et des rangs de division Ni, l'erreur de phase commise étant désignée par $\Delta\varphi$.

On peut montrer que l'acceptation d'une variation d'une unité sur le rang de division Ni d'un cycle de comptage au suivant permet de générer des pentes considérables. Il n'est donc plus nécessaire que la mémoire du circuit de commande 3 contienne toutes les valeurs du rang de division.

Il suffit qu'elle contienne le rang initial No lié à la fréquence initiale fo du signal modulé S et à la fréquence horloge par la relation:

$$f_o = \frac{f_H}{2N_o}$$

ainsi que la variation de chaque rang Ni (i = 1,...,n) par rapport au rang précédent $N_{i-1}$. La capacité mémoire nécessaire est donc très inférieure à celle de la mémoire 32 du premier mode de réalisation du circuit de commande 3 représenté par la fig. 3.

Le circuit de commande 3 devient donc celui qui est représenté sur la fig. 4 dans lequel les références 30 et 31 désignent des circuits identiques à ceux utilisés dans la fig. 3, à savoir une bascule R/S 30 recevant un signal Sd de début et un signal Sf de fin et délivre un signal $S_{RAZ}$ de remise à zéro ou réinitialisation, et un compteur d'adresses 31 dont la remise à zéro est assurée par le signal $S_{RAZ}$ de la bascule 30 et qui commande une mémoire 34 au rythme de l'arrivée des impulsions fines de retenue R (du circuit diviseur programmable 1 de la fig. 1) sur son entrée horloge H.

La mémoire 34 nécessitant une capacité inférieure à celle de la mémoire 32 de la fig. 3, comme on l'a déjà mentionné ci-dessus délivre des impulsions a et b servant à l'incrémentation ou à la décrémentation d'un compteur-décompteur 33 par l'intermédiaire d'un ensemble de portes ET 35, 36.

La porte ET 35, respectivement 36, reçoit sur sa première entrée l'élément binaire a, respectivement b, et sur sa deuxième entrée l'impulsion R de retenue délivrée par le diviseur programmable 1 de la fig. 1 et délivre un signal commandant la décrémentation, respectivement l'incrémentation, du compteur-décompteur 33 dont le prépositionnement est assuré par le signal de sortie $S_{RAZ}$ de la bascule R/S 30.

Les deux éléments binaires a et b sont de plus combinés par une porte ET 37 en un signal Sf de fin de séquence qui est appliqué à l'entrée de la bascule R/S.

Les éléments binaires a et b ont suivant leur état la signification suivante:

a = 0 et b = 0: Ni = $N_{i-1}$. Il ne se produit ni décrémentation ni incrémentation du compteur 33.
a = 0 et b = 1: Ni = $N_{i-1}$+1. Le compteur 33 est incrémenté d'une unité.
a = 1 et b = 0: Ni = $N_{i-1}$ –1. Le compteur 33 est décrémenté d'une unité
a = 1 et b = 1. Il y a arrêt de la séquence et remise à zéro puisque la bascule R/S 30 reçoit un signal de fin Sf.

Le compteur-décompteur 33 fournit au diviseur programmable 1 de la fig. 1 le rang Ni de la division. Il délivre également éventuellement un signal de commande Sm au circuit 4 de la fig. 1 qui permet d'utiliser des fréquences d'horloge inférieures avec une même précision de phase.

Selon un exemple non limitatif ce signal de commande peut être constitué par l'élément binaire de plus petit poids (LSB), les autres éléments binaires étant appliqués à l'entrée du diviseur programmable 1 (Fig. 1).

L'incrément de temps servant à la génération du signal étant la période T de l'horloge

$$T = \frac{1}{f_H},$$

le rang Ni de division est déterminé pour que les changements d'état du signal de sortie S se fassent au moment idéal

$$\pm \frac{T}{2} = \pm \frac{1}{2f_H}$$

L'erreur de phase $\Delta\varphi$ maximale ainsi créée est égale a:

$$\Delta\varphi = \frac{2\pi \times \frac{T}{2}}{\frac{1}{f}} = \frac{\pi f}{f_H},$$

où f est la fréquence du signal S généré par le dispositif 10. On peut donc choisir la fréquence d'horloge en fonction de la précision de phase souhaitée.

Si l'on a besoin d'obtenir une modulation de fréquence particulièrement précise, une première solution consiste à utiliser une fréquence horloge $f_H$ très élevée, par exemple de l'ordre de 100 MHz ou plus.

Or une division programmable à une telle fréquence se révèle particulièrement difficile à réaliser: peu de composants le permettent.

Il est donc intéressant de pouvoir garder la même précision de phase $\Delta\varphi$ tout en diminuant la fréquence horloge.

Les fig. 6 et 8 donnent deux exemples non limitatifs de réalisation d'un circuit (circuit 4 de la fig. 1) permettant de travailler à une fréquence horloge moins élevée que celle qui est nécessaire en l'absence d'un tel circuit 4, tout en assurant une précision de phase identique.

Dans le cas du mode de réalisation de la fig. 6 décrit ci-après en se référant également à la fig. 7 représentant les signaux en différents points du circuit, on suppose que le signal d'horloge a un facteur de forme de ½. Le signal de sortie S du circuit 2 diviseur par deux alimente la première entrée de deux bascules du type D 41 et 42 recevant sur leur deuxième entrée le signal d'horloge de fréquence $f_H$ et fonctionnant sur front montant et sur front descendant respectivement.

La sortie SQ1, respectivement SQ2, de la bascule type D 41, respectivement 42, est appliquée sur la première, respectivement deuxième, entrée d'un circuit multiplexeur 40, commandé par le signal Sm fourni par le circuit 3 (par le compteur-décompteur 33 de la fig. 4 ou par la mémoire 32 de la fig. 3).

Etant donné le mode de fonctionnement des deux bascules D 41 (front montant) et 42 (front descendant), les deux signaux de sortie SQ1 et SQ2 sont donc décalés dans le temps d'une demi-période d'horloge.

Le circuit multiplexeur 40 commandé par le signal Sm, sélectionne à chaque alternance le signal SQ1 ou SQ2 qu'il délivre en sortie. Le signal S' se compose donc d'alternances appartenant soit à SQ1 soit à SQ2. La précision de la phase est donc, pour une même fréquence d'horloge, multipliée par deux.

La fig. 8 représente un autre mode de réalisation du circuit 4 permettant d'améliorer la précision de phase du signal généré par le dispositif 10 selon l'invention (fig. 1). Les signaux générés en différents points de ce circuit sont représentés sur la fig. 9 à laquelle on se réfère également dans la description ci-après.

Le circuit 4 de la fig. 8 utilise une ligne à retard 44 présentant un nombre M de plots de sortie, (au nombre de trois dans la fig. 8) espacés de

$$\frac{T}{M+1} ,$$

T étant la période

$$\frac{1}{f_H}$$

du signal d'horloge.

Le signal S en sortie du circuit 2 diviseur par deux (Fig. 1) est appliqué à l'entrée de la ligne à retard 44 et sur une première entrée d'un circuit multiplexeur 43 à (M+1) entrées, commandé par le signal de commande Sm fourni par le circuit 3 de la fig. 3 (en sortie de la mémoire 32) ou de la fig. 4 (en sortie du compteur-décompteur 33).

Les M autres entrées du multiplexeur 43 sont alimentées par les signaux $S_1,...,S_M$ délivrés par les M plots de sortie de la ligne à retard 44. Ces signaux correspondent au signal S retardé, pour le plot d'ordre j (j = 1,..., M), de

$$\frac{jT}{M+1}$$

par rapport au signal S. C'est ce qui est représenté sur la fig. 9 pour M = 3.

Comme le multiplexeur 40 du mode de réalisation de la fig. 6, le multiplexeur 43 choisit à chaque alternance parmi les (M+1) entrées alimentées respectivement par les signaux $S_1,...,$ $S_i,..., S_M$, le signal le mieux adapté pour obtenir la meilleure précision de phase.

Dans ce mode de réalisation la précision est améliorée dans un rapport (M+1).

Il est à noter qu'il est avantageux d'utiliser une ligne à retard telle que (M+1) soit un multiple de deux. Ainsi la commande du multiplexeur peut être fournie directement par le compteur-décompteur 33 de la fig. 4 lorsque le circuit 4 est utilisé en association avec le circuit 3 de la fig. 4.

Il faut également noter que dans le mode de réalisation de la fig. 8, le circuit 4 est alimenté par le signal S de sortie du circuit 2 diviseur par deux. Le circuit 4 représenté pourrait également, selon un autre mode de réalisation (non représenté) du dispositif de la fig. 1 être inséré entre le décompteur programmable 1 et le diviseur par deux 2.

Le circuit 4 de la fig. 8 est alors alimenté, non plus par le signal S, mais par le signal de retenue R à condition toutefois que la commande du multiplexeur 43 se fasse à un instant où le signal est stable de façon à ne pas créer de perturbation sur le signal de sortie.

La fig. 10 représente un exemple de boucle de phase, dont la technique est connue mais qui utilise un dispositif de génération numérique 10 selon l'invention.

En effet comme on l'a déjà mentionné plus haut, la fréquence du signal généré se trouve dans la gamme de fréquences accessibles aux circuits numériques, soit du contenu à quelques dizaines de MHz.

La boucle de phase de la fig. 10 permet de transposer ce signal à n'importe quelle fréquence porteuse et d'obtenir donc un signal, par exemple hyperfréquence, présentant une modulation de fréquence très précise.

Dans l'exemple non limitatif de la fig. 10, on apelle f la fréquence du signal S (ou S' s'il y a un circuit 4 de précision de phase) délivré par le dispositif numérique 10 selon l'invention, et F1 la fréquence fixe de l'oscillateur 11.

La fréquence du signal utile Su en sortie de l'oscillateur 17 commandé en fréquence est de F1+Nf.

Le signal utile Su alimente le mélangeur 12 qui reçoit sur sa deuxième entrée le signal de sortie de l'oscillateur 11 de fréquence fixe F1. Le signal de sortie du mélangeur 12, traverse un filtre passe-bas 13 pour alimenter à la fréquence Nf un circuit 14 diviseur par N.

Un comparateur de phase 15 reçoit sur sa première entrée le signal S (ou S') de fréquence f modulée en fréquence, délivré par le dispositif numérique 10, objet de la présente invention et sur sa deuxième entrée le signal de sortie du diviseur par N 14.

La sortie du comparateur de phase 15 est utilisée par le circuit de commande 16 pour commander la fréquence F1+Nf de l'oscillateur 17.

Dans ce type d'application, le dispositif numérique 10 peut être encore simplifié si on utilise, comme comparateur de phase, un comparateur fréquence-phase comme par exemple le comparateur II du circuit CMOS 4046. En effet dans ce cas seuls les fronts montants sont utilisés. On n'a donc plus besoin de générer les deux fronts du signal S mais un seul.

Le décompteur programmable 1 ne compte alors plus les demi-périodes mais les périodes entières du signal à générer. Pour un même signal, moitié moins de cycles de décomptage sont alors nécessaires. La capacité mémoire du circuit 3 peut donc être divisée par deux.

On a ainsi décrit un dispositif très performant générant numériquement un signal présentant n'importe quelle modulation de fréquence tout en utilisant une fréquence d'horloge qui autorise l'emploi de circuits moins rapides, par exemple TTL au lieu de ECL.

La présente invention est applicable aux radars hyperfréquence.

## Revendications

1. Dispositif de génération numérique d'un signal modulé en fréquence selon une loi déterminée, comportant une horloge (5) de période $T = 1/f_H$, un moyen diviseur programmable (1) générant un signal impulsionnel R dont chaque période d'ordre i est un multiple entier $N_i$ supérieur à 1, i variant de 0 à n, de la période T de l'horloge (5), et dont la largeur d'impulsion est égale à une période T d'horloge, un moyen (2) de mise en forme dudit signal impulsionnel R en un signal S dont les (n+1) alternances correspondent respectivement aux (n+1) périodes dudit signal impulsionnel R, et un moyen (3) de commande dudit moyen diviseur programmable (1), auquel il fournit successivement chacun des nombres naturels $N_0,...,$ $N_n$, caractérisé en ce que ledit moyen de commande (3) assure la réinitialisation dudit moyen de mise en forme (2) et en ce que le dispositif comprend en outre un moyen de retard (4) pour délivrer sur (M+1) sorties le signal fourni par le moyen programmable (1) et retardé respectivement de

$$\frac{jT}{M+1},$$

j variant de 0 à M, T étant la période d'horloge et M étant un nombre naturel supérieur ou égal à 1, et un moyen permettant de sélectionner, pour chaque cycle de comptage d'ordre i, un des (M+1) signaux de sortie du moyen de retard.

2. Dispositif selon la revendication 1, caractérisé en ce que le moyen de retard est constitué de deux bascules (41 et 42) de type D, l'une fonctionnant sur front montant, l'autre sur front descendant du signal d'horloge, à l'entrée desquelles est appliqué le signal de sortie du moyen diviseur programmable (1) après mise sous forme du signal S par le moyen de mise en forme (2), M étant alors égal à 1.

3. Dispositif selon la revendication 1, caractérisé en ce que le moyen de retard est constitué par une ligne à retard délivrant sur (M+1) sorties le signal appliqué à l'entrée et retardé respectivement d'une quantité

$$\frac{jT}{M+1},$$

j variant de 0 à M, par rapport au signal d'entrée.

4. Dispositif selon la revendication 3, caractérisé en ce que le signal appliqué à l'entrée de la ligne à retard est le signal impulsionnel R délivré par le moyen diviseur programmable (1).

5. Dispositif selon la revendication 3, caractérisé en ce que le signal appliqué à l'entrée est le signal délivré par le moyen diviseur programmable (1) après mise sous forme du signal modulé (S) par le moyen de mise en forme (2).

6. Dispositif selon l'une quelconque des revendications 1 à 5, caractérisé en ce que le moyen de sélection est un circuit multiplexeur commandé par un signal Sm délivré par le moyen de commande (3) et comportant (M+1) entrées et une sortie.

7. Dispositif selon la revendication 1, caractérisé en ce que le moyen diviseur programmable (1) est un décompteur dont le contenu subit, à chaque cycle d'horloge une décrémentation d'une unité, depuis la valeur $N_i-1$, le nombre naturel $N_i$ étant fourni par le moyen de commande (3) au début de chaque cycle de comptage, jusqu'à la valeur 0 marquant la fin du cycle de comptage d'ordre i et correspondant à l'émission par le décompteur d'une impulsion de largeur T qui coïncide avec le N-ième et dernier cycle d'horloge du i-ième cycle de comptage et provoque le chargement dans le décompteur de la valeur $N_{i+1}-1$, les nombres naturels $N_i$, i compris entre 0 et n, étant successivement fournis par le moyen de commande (3).

8. Dispositif selon la revendication 1, caractérisé en ce que le moyen diviseur programmable (1) est un compteur programmable dont le contenu subit à chaque cycle d'horloge une incrémentation d'une unité depuis la valeur $N_M+1-N_i$ jusqu'à la valeur $N_M$ marquant la fin du cycle de comptage d'ordre i et correspondant à l'émission par le compteur d'une impulsion de largeur T qui coïncide avec le N-ième et dernier cycle d'horloge du i-ième cycle de comptage et provoque le chargement dans le compteur de la valeur $N_M+1 -N_{i+1}$, les nombres naturels $N_i$ étant fournis par le moyen de commande (3) et $N_M$ étant la valeur maximum donnée que peut afficher le compteur (1).

9. Dispositif selon la revendication 1, caractérisé en ce que le moyen de mise en forme (2) est un circuit diviseur de fréquence par deux délivrant un signal dont les (n+1) alternances ont respectivement une durée $N_0T,..., N_iT,...,N_nT$.

10. Dispositif selon la revendication 1, caractérisé en ce que le moyen de commande (3) comprend:

– un compteur d'adresses (31) affichant successivement les adresses $A_i$, i variant de 0 à n, par incrémentation au rythme du signal impulsionnel R délivré par le moyen diviseur programmable (1);

– un circuit mémoire (32) déterminant et délivrant vers le moyen diviseur programmable (1) le nombre naturel $N_i$ qui doit correspondre à l'adresse $A_i$ affichée par ledit compteur d'adresses (31), un signal de commande Sm et lorsque le contenu du circuit mémoire a été exploré un signal Sf de fin d'exploration; et

– une bascule du type R/S qui reçoit sur sa première entrée un signal extérieur Sd pour déclencher le dispositif numérique (10) et sur sa deuxième entrée le signal Sf de fin d'exploration délivré par ledit circuit mémoire et qui délivre sur sa sortie Q un signal $S_{RAZ}$ assurant la réinitialisation des moyens diviseur programmable (1) et de mise en forme (2) et la remise à zéro du compteur d'adresses (31).

11. Dispositif selon la revendication 10, caractérisé en ce que le circuit mémoire est une mémoire morte adressable par (n+1) adresses A0,..., An à chacune desquelles correspond respectivement un nombre naturel N0,...,Nn, l'adresse An contenant, en plus du nombre relatif Nn un premier et un deuxième élément binaire qui émis constituent les signaux Sf de fin d'exploration et Sm de commande respectivement.

12. Dispositif selon la revendication 10, caractérisé en ce que le circuit mémoire comprend:

– un compteur-décompteur (33) dont le prépositionnement à la valeur initiale N0 correspondant à l'adresse A0 est assuré par le signal $S_{RAZ}$ délivré par la sortie Q de la bascule R/S (30), qui présente une entrée comptage et une entrée décomptage, et qui délivre la valeur Ni correspondant à l'adresse Ai affichée par le compteur d'adresse (31);

– une mémoire morte (34) adressable par le compteur d'adresses (31) et délivrant pour chaque adresse Ai, un couple d'éléments binaires (ai, bi), i variant de 0 à n, qui après avoir été combinés au signal de retenue R dans un premier moyen de combinaison logique (35, 36), sont appliqués aux entrées décomptage et comptage respectivement du compteur-décompteur (33) et provoquent soit la décrémentation soit l'incrémentation dudit compteur-décompteur (33) d'une unité ou son maintien par rapport à la valeur Ni+1 correspondant à l'adresse précédemment affichée par le compteur d'adresse, les éléments binaires (ai, bi) étant combinés dans un deuxième moyen de combinaison logique en un signal Sf appliqué sur la deuxième entrée de la bascule R/S (30) pour signaler la fin de l'exploration du contenu de la mémoire (34).

13. Dispositif numérique selon la revendication 12, caractérisé en ce que le compteur-décompteur (33) délivre un signal de commande Sm formé par l'élément binaire de poids le plus faible de la valeur Ni délivrée.

14. Dispositif radio-fréquence comportant un dispositif (10) selon l'une quelconque des revendications 1 à 13 délivrant un signal de fréquence modulée f, caractérisé en ce qu'il comporte en outre un premier oscillateur (11) à fréquence fixe F1, un deuxième oscillateur (17) à commande en fréquence F2, un mélangeur (12) qui reçoit sur ses deux entrées les signaux de fréquence F1 et F2 respectivement et qui applique par l'intermédiaire d'un filtre passe-bas (13) et d'un circuit (14) diviseur par N, N étant un nombre entier positif non nul, un signal de fréquence (F2–F1)/N sur la première entrée d'un comparateur de phase (15), qui recevant sur sa deuxième entrée le signal de fréquence f modulée délivré par le dispositif numérique (10), délivre un signal servant à commander la fréquence F2 du deuxième oscillateur pour la rendre égale à F1+Nf.

15. Dispositif radiofréquence selon la revendication 14 caractérisé en ce que le comparateur de phase (15) est un comparateur fréquence-phase fonctionnant sur fronts montants ou descendants, le dispositif (10) ne délivrant que les périodes entières du signal (S).

## Patentansprüche

1. Vorrichtung zur digitalen Erzeugung eines gemäss einem bestimmten Gesetz frequenzmodulierten Signals, mit einem Taktgeber (5) der Periode $T = 1/f_H$, einer programmierbaren Teilereinrichtung (1), welche ein Impulssignal R erzeugt, bei dem jede Periode der Ordnungszahl i ein ganzzahliges Vielfaches Ni grösser als 1, worin i zwischen 0 und n variiert, der Periode T des Taktgebers (5) ist und bei welchem die Impulsbreite gleich einer Taktperiode T ist, einer Formgebungseinrichtung (2) zur Formung des genannten Impulssignals R zu einem Signal S, bei welchem die (n+1) Halbschwingungen jeweils den (n+1) Perioden des genannten Impulssignals R entsprechen, und einer Steuereinrichtung (3) zur Steuerung der genannten programmierbaren Teilereinrichtung (1), zu welcher sie nacheinander jede der natürlichen Zahlen N0,...,Nn liefert, dadurch gekennzeichnet, dass die genannte Steuereinrichtung (3) die Neuinitiierung der genannten Formgebungseinrichtung (2) gewährleistet und dass die Vorrichtung ferner eine Verzögerungseinrichtung (4) enthält, um auf (M+1) Ausgängen das Signal zu liefern, welches durch die programmierbare Einrichtung (1) geliefert wird, jeweils verzögert um

$$\frac{jT}{M+1} \, ,$$

worin j von 0 bis M variiert und T die Taktperiode sowie M eine natürliche Zahl grösser als oder gleich 1 ist, sowie eine Einrichtung enthält, die es gestattet, für jeden Zählzyklus der Ordnungszahl i eines der (M+1) Ausgangssignale der Verzögerungseinrichtung auszuwählen.

2. Vorrichtung nach Anspruch 1, dadurch gekennzeichnet, dass die Verzögerungseinrichtung aus zwei Kippschaltungen (41 und 42) vom D-Typ gebildet ist, von denen die eine auf die Anstiegsflanke und die andere auf die Abfallflanke des Taktsignals anspricht und an deren Eingang das Ausgangssignal der programmierbaren Teilereinrichtung (1) nach Formung des Signals S durch die Formgebungseinrichtung (2) angelegt ist, wobei M dann gleich 1 ist.

3. Vorrichtung nach Anspruch 1, dadurch gekennzeichnet, dass die Verzögerungseinrichtung durch eine Verzögerungsleitung gebildet ist, welche auf (M+1) Ausgängen das an den Eingang angelegte Signal jeweils um eine Grösse

$$\frac{jT}{M+1} \, ,$$

worin j von 0 bis M variiert, gegenüber dem Eingangssignal verzögert abgibt.

4. Vorrichtung nach Anspruch 3, dadurch gekennzeichnet, dass das an den Eingang der Verzögerungsleitung angelegte Signal das Impulssignal R ist, welches durch die programmierbare Teilereinrichtung (1) abgegeben wird.

5. Vorrichtung nach Anspruch 3, dadurch gekennzeichnet, dass das an den Eingang angelegte Signal das Signal ist, welches durch die programmierbare Teilereinrichtung (1) nach Formung des modulierten Signals (S) durch die Formgebungseinrichtung (2) abgegeben wird.

6. Vorrichtung nach einem der Ansprüche 1 bis 5, dadurch gekennzeichnet, dass die Auswahleinrichtung eine Multiplexschaltung ist, welche durch ein Signal Sm gesteuert wird, das die Steuereinrichtung (3) abgibt, und die (M+1) Eingänge sowie einen Ausgang aufweist.

7. Vorrichtung nach Anspruch 1, dadurch gekennzeichnet, dass die programmierbare Teilereinrichtung (1) ein Abwärtszähler ist, dessen Inhalt bei jedem Taktzyklus eine Dekrementierung um eine Einheit ausgehend vom Wert $Ni-1$ erfährt, wobei die natürliche Zahl $Ni$ durch die Steuereinrichtung (3) zu Beginn jedes Zählzyklus geliefert wird, bis zum dem Wert 0, welcher das Ende des Zählzyklus der Ordnungszahl i markiert und der Abgabe eines Impulses der Breite T durch den Abwärtszähler entspricht, welcher mit dem N-ten und letzten Taktzyklus des i-ten Zählzyklus zusammenfällt und das Laden des Wertes $N_{i+1}-1$ in den Abwärtszähler verursacht, wobei die natürlichen Zahlen $Ni$, i zwischen 0 und n, nacheinander durch die Steuereinrichtung (3) geliefert werden.

8. Vorrichtung nach Anspruch 1, dadurch gekennzeichnet, dass die programmierbare Teilereinrichtung (1) ein programmierbarer Zähler ist, dessen Inhalt bei jedem Taktzyklus eine Inkrementierung um eine Einheit ausgehend vom Wert $N_M+1-N_i$ bis zum Wert $N_M$ erfährt, welcher das Ende des Zählzyklus der Ordnungszahl i markiert und der Abgabe eines Impulses der Breite T durch den Zähler entspricht, welcher mit dem N-ten und letzten Taktzyklus des i-ten Zählzyklus zusammenfällt sowie das Laden des Wertes $N_M+1-N_{i+1}$ in den Zähler verursacht, wobei die natürlichen Zahlen $Ni$ durch die Steuereinrichtung (3) geliefert werden und $N_M$ der maximale gegebene Wert ist, den der Zähler (1) anzeigen kann.

9. Vorrichtung nach Anspruch 1, dadurch gekennzeichnet, dass die Formgebungseinrichtung (2) eine Frequenzteilerschaltung ist, die durch zwei teilt und ein Signal abgibt, bei dem die $(n+1)$ Halbschwingungen jeweils eine Dauer $N_0T,...,N_iT,...,N_nT$ aufweisen.

10. Vorrichtung nach Anspruch 1, dadurch gekennzeichnet, dass die Steuereinrichtung (3) umfasst:

– einen Adressenzähler (31), welcher nacheinander die Adressen Ai anzeigt, worin i von 0 bis n variiert, durch Inkrementierung im Rhythmus des Impulssignals R, welches durch die programmierbare Teilereinrichtung (1) abgegeben wird;
– eine Speicherschaltung (32), welche an die programmierbare Teilereinrichtung (1) die natürliche Zahl Ni, welcher der durch den genannten Adressenzähler (31) angezeigten Adresse Ai entsprechen muss, ein Steuersignal Sm und nach Abfragung des Inhalts der Speicherschaltung ein Signal Sf für das Abfrageende abgibt und bestimmt; und
– eine R/S-Kippschaltung, die an ihrem ersten Eingang ein externes Signal Sd zur Auslösung der digitalen Vorrichtung (10) und an ihrem zweiten Eingang das von der Speicherschaltung abgegebene Signal Sf für das Abfrageende empfängt sowie an ihrem Ausgang Q ein Signal $S_{RAZ}$ abgibt, welches die Neuinitiierung der programmierbaren Teilereinrichtung (1) und der Formgebungseinrichtung (2) sowie die Nullrücksetzung des Adressenzählers (31) gewährleistet.

11. Vorrichtung nach Anspruch 10, dadurch gekennzeichnet, dass die Speicherschaltung ein Festwertspeicher ist, der durch $(n+1)$ Adressen Ao,...,An adressierbar ist, denen jeweils eine natürliche Zahl No,...,Nn entspricht, wobei die Adresse An ausser der relativen Zahl Nn ein erstes sowie ein zweites Binärelement enthält, die bei Aussendung die Signale Sf für das Abfrageende bzw. Sm für die Steuerung bilden.

12. Vorrichtung nach Anspruch 10, dadurch gekennzeichnet, dass die Speicherschaltung enthält:

– einen Aufwärts/Abwärts-Zähler (33), dessen Voreinstellung auf den Anfangswert N0 entsprechend der Adresse A0 durch das Signal $S_{RAZ}$ gewährleistet wird, welches am Q-Ausgang der R/S-Kippschaltung (30) abgegeben wird, der einen Aufwärts-Zähleingang und einen Abwärts-Zähleingang aufweist sowie den Wert Ni ausgibt, welcher der durch den Adressenzähler (31) angezeigten Adresse Ai entspricht;
– einen Festwertspeicher (34), der duch den Adressenzähler (31) adressierbar ist und für jede Adresse Ai ein Binärelementpaar (ai, bi) abgibt, worin i von 0 bis n variiert, dessen Binärelemente nach Kombination mit dem Haltesignal R in einer ersten logischen Kombinationseinrichtung (35, 36) an den Abwärts- bzw. Aufwärts-Zähleingang des Aufwärts/Abwärts-Zählers (33) angelegt werden und entweder die Dekrementierung oder die Inkrementierung des genannten Aufwärts/Abwärts-Zählers (33) um eine Einheit oder sein Festhalten bezüglich des Wertes Ni+1 verursachen, welcher der zuvor durch den Adressenzähler angezeigten Adresse entspricht, wobei die Binärelemente (ai, bi) in einer zweiten logischen Kombinationseinrichtung zu einem Signal Sf kombiniert werden, welches an den zweiten Eingang der R/S-Kippschaltung (30) angelegt wird, um das Ende der Abfragung des Inhalts des Speichers (34) zu signalisieren.

13. Digitale Vorrichtung nach Anspruch 12, dadurch gekennzeichnet, dass der Aufwärts/Abwärts-Zähler (33) ein Steuersignal Sm abgibt, welches durch das Binärelement geringster Wertigkeit des ausgegebenen Wertes Ni gebildet ist.

14. Funkfrequenz-Vorrichtung mit einer Vorrichtung (10) nach einem der Ansprüche 1 bis 13, welche ein Signal der modulierten Frequenz f abgibt, dadurch gekennzeichnet, dass sie ferner einen ersten Oszillator (11) mit fester Frequenz F1 enthält, einen zweiten Oszillator (17) mit gesteuerter Frequenz F2, einen Mischer (12), der an seinen zwei Eingängen die Signale der Frequenz F1 bzw. F2 empfängt und über ein Tiefpassfilter (13) und eine durch N teilende Teilerschaltung (14), worin N eine ganze positive Zahl ungleich Null ist, ein Signal der Frequenz (F2–F1)/N an den ersten Eingang eines Phasenkomparators (15) anlegt, der an seinem zweiten Eingang das Signal mit der modulierten Frequenz f empfängt, welches die digitale Vorrichtung (10) abgibt, und ein Signal ausgibt, welches zur Steuerung der Frequenz F2 des zweiten Oszillators dient, damit diese gleich F1+Nf ist.

15. Funkfrequenz-Vorrichtung nach Anspruch 14, dadurch gekennzeichnet, dass der Phasenkomparator (15) ein Frequenz-Phasen-Komparator ist, der auf die Anstiegsflanken oder Abfallflanken anspricht, wobei die Vorrichtung (10) nur die ganzen Perioden des Signals (S) ausgibt.

**Claims**

1. Device for the digital generation of a signal which is frequency modulated according to a determined law, comprising a clock (5) of the period $T = 1/f_H$, programmable divider means (1) generating a pulse signal R each period of the order i of which is an entire multiple Ni exceeding 1, i varying from 0 to n, of the period T of the clock (5), and the pulse width of which is equal to a clock period T, means (2) for shaping said pulse signal R into a signal S the (n+1) half periods of which respectively correspond to the (n+1) periods of said pulse signal R, and means (3) for controlling said programmable divider means (1) whereto these means successively supply each of the natural numbers No,...,Nn, characterized in that said control means (3) ensure the reinitialisation of said shaping means (2) and in that said device further comprises delay means (4) for supplying on (M+1) outputs the signal supplied by the programmable means (1) and respectively delayed by

$$\frac{jT}{M+1},$$

j varying from 0 to M, T being the clock period and M being a natural number greater than or equal to 1, and means permitting to select one of the (M+1) output signals of the delay means for each counting cycle of the order i.

2. Device according to claim 1, characterized in that the delay means are formed of two D type flip-flops (41 and 42) one of which responds to the rising edge and the other of which responds to the falling edge of the clock signal, and to the input of which the output signal of the programmable divider means (1) is applied after the shaping of the signal S by the shaping means (2), M then being equal to 1.

3. Device according to claim 1, characterized in that the delay means is formed of a delay line supplying on (M+1) outputs the signal applied to the input and respectively delayed by a quantity

$$\frac{jT}{M+1},$$

j varying from 0 to M, with respect to the input signal.

4. Device according to claim 3, characterized in that the signal applied to the input of the delay line is the pulse signal R supplied by the programmable divider means (1).

5. Device according to claim 3, characterized in that the signal applied to the input is the signal supplied by the programmable divider means (1) after shaping of the modulated signal (S) by the shaping means (2).

6. Device according to any of claims 1 to 5, characterized in that the selection means is a multiplexing circuit controlled by a signal Sm supplied by the control means (3) and comprising (M+1) inputs and one output.

7. Device according to claim 1, characterized in that the programmable divider means (1) is a downward counter the input of which is decremented by one unit in each clock cycle starting from the value Ni–1, the natural number Ni being supplied by the control means (3) at the beginning of each counting cycle, to the value 0 marking the end of the counting cycle of the order i and corresponding to the delivery by the downward counter of a pulse having the width T and being coincident with the N-th and last clock cycle of the i-th counting cycle and causes the loading of the value $N_{i+1}-1$ into the downward counter, the natural numbers Ni, i comprised between 0 and n, being successively supplied by the control means (3).

8. Device according to claim 1, characterized in that the programmable divider means (1) is a programmable counter the content of which is incremented in each clock cycle by one unit from the value $N_M+1-N_i$ to the value $N_M$ marking the end of the counting cycle of the order i and corresponding to the delivery by the counter of a pulse having the width T and being coincident with the N-th and last clock cycle of the i-th counting cycle, and causes the value $N_M+1-N_{i+1}$ to be loaded into the counter, the natural numbers Ni being supplied by the control means (3) and $N_M$ being the given maximum value the counter (1) can display.

9. Device according to claim 1, characterized in that the shaping means (2) is a frequency divider by two supplying a signal the (n+1) half periods of which respectively have the duration $N_0T,...,N_iT,...,N_nT$.

10. Device according to claim 1, characterized in that the control means (3) comprise:

– an address counter (31) successively displaying the addresses Ai, i varying from 0 to n, by incrementation at the rhythm of the pulse R supplied by the programmable divider means (1);

- a memory circuit (32) determining and supplying to the programmable divider means (1) the natural number Ni susceptible to correspond to the address Ai displayed by said address counter (31), a control signal Sm and a reading end signal Sf when the content of the memory circuit has been read; and

- a R/S flip-flop receiving on its first input an external signal Sd for the triggering of the digital device (10) and on its second input the reading end signal Sf supplied by said memory circuit, and supplying on its output Q a signal $S_{RAZ}$ ensuring the reinitialisation of the programmable divider means (1) and the shaping means (2) and the zero resetting of the address counter (31).

11. Device according to claim 10, characterized in that the memory circuit is a read-only memory addressable by (n+1) addresses Ao,...,An each associated with a corresponding natural number No,...,Nn, the addresse An containing, in addition to the relative number Nn, a first and a second binary element which, upon delivery, form the reading end signal Sf and the control signal Sm, respectively.

12. Device according to claim 10, characterized in that the memory circuit comprises:

- an upward/downward counter (33) the presetting of which to the initial value N0 corresponding to the address A0 is ensured by the signal $S_{RAZ}$ supplied by the output Q of the R/S flip-flop (30), having an upward counting input and a downward counting input, and supplying the value Ni corresponding to the address Ai displayed by the address counter (31);

- a read-only memory (34) addressable by the address counter (31) and supplying for each address Ai a couple of binary elements (ai, bi), i varying from 0 to n, which are applied, after having been combined with the holding signal R in a first logic combination means (35, 36), to the downward counting and upward counting inputs, respectively, of the upward/downward counter (33), and causing either the decrementation or the incrementation of said upward/downward counter (33) by one unit or its holding with respect to the value Ni+1 corresponding to the address precedingly displayed by the address counter, the binary elements (ai, bi) being combined in a second logic combination means into a signal Sf applied to the second input of the R/S flip-flop (30) to signal the end of reading of the content of the memory (34).

13. Digital device according to claim 12, characterized in that the upward/downward counter (33) supplies a control signal Sm formed by the least significant binary element of the supplied value Ni.

14. A radio frequency device comprising a device (10) according to any of claims 1 to 13, supplying a signal of modulated frequency f, characterized in that it further comprises a first fixed frequency F1 oscillator (11), a second, controlled frequency F2 oscillator (17) and a mixer (12) receiving on its two inputs the signals of the frequencies F1 and F2, respectively, and applying through a low-pass filter (13) and a divider circuit (14) by N, N being a positive integer not equal to 0, a signal of the frequency (F2-F1)/N to the first input of a phase comparator (15) which receives on its second input the signal of modulated frequency f supplied by the digital device (10) and supplies a signal which is used to control the frequency F2 of the second oscillator to make it equal to F1+Nf.

15. Radio frequency device according to claim 14, characterized in that the phase comparator (15) is a frequency-phase comparator responding to the rising or falling edges, the device (10) supplying only the entire periods of the signal (S).

# FIG_1

# FIG_2

# FIG_3

0 088 669

FIG_4

FIG_5

13

0 088 669

# FIG_6

# FIG_7

# FIG_8

# FIG_9

# FIG_10